# EUROPEAN PATENT APPLICATION

(11) **EP 4 518 117 A1**
(43) Date of publication of application: **05.03.2025**
(21) Application number: 23795080.3
(22) Date of filing: 17.04.2023
(51) Int. Cl.: H02M 1/00, H02M 7/00

(54) **ELECTRICAL DEVICE, ELECTRICAL DEVICE HANGING SYSTEM, AND PHOTOVOLTAIC POWER STATION**

(30) Priority: 24.04.2022 CN 202220973190 U
(71) Applicant: Sungrow Power Supply Co., Ltd., Hefei, Anhui 230088 (CN)
(72) Inventor: SHEN, Zhanliang, Hefei, Anhui 230088 (CN); XING, Jun, Hefei, Anhui 230088 (CN)
(74) Representative: Zacco Norway AS
(86) International application number: PCT/CN2023/088600
(87) International publication number: WO 2023/207647

(57) **Abstract**

Disclosed in the present utility model is an electrical device, comprising a box body and a plurality of hanging members. Apparatuses are provided outside the box body; the handing members are respectively fixed to the apparatuses, and a first handing member and a second hanging member in the hanging members are distributed on two sides of the box body. The hanging members in the electrical device are mounted on the apparatuses outside the box body instead of being directly mounted on the box body, such that the area of the box body is saved, the box body is prevented from being set to be larger due to the assembly of the hanging members, and the miniaturization requirements in the prior art on the electrical device are met. In addition, the box body does not need to be set to be large, and the cost can be saved. Further disclosed in the present utility model are an electrical device hanging system and a photovoltaic power station which respectively use the electrical device, and the miniaturization requirements in the prior art on the electrical device are met.

## Description

This application claims the priority of the Chinese Patent Application No. 202220973190.5, titled "ELECTRICAL DEVICE, ELECTRICAL DEVICE HANGING SYSTEM, AND PHOTOVOLTAIC POWER STATION", filed on April 24, 2022 with the China National Intellectual Property Administration, which is incorporated herein by reference in its entirety.

### FIELD

The present application relates to the technical field of mounting of electrical devices, and in particular to an electrical device, an electrical device hanging system, and a photovoltaic power station.

### BACKGROUND

With the increasing power capacity of the electrical device such as an inverter and a combiner box, requirements for miniaturization of electrical devices in the photovoltaic industry becomes higher.

In the conventional technology, an electrical device is provided with a hanging bracket having a hanging structure, and the hanging structure is used to fit with a hanging plate provided in a foundation including a wall and the like. The hanging bracket is mounted on a back of a box body of the electrical device, occupying a large area of the box body, thus a larger box body is needed, which makes it difficult to meet the miniaturization requirements of the electrical device.

In addition, the large size of the box body results in a high cost.

Therefore, a technical problem to be solved by those skilled in the art is to avoid the size of the box of the electrical device from being too large due to assembly with the hanging bracket.

### SUMMARY

In view of this, an electrical device is provided in the present application, where a hanging member of the electrical device is mounted to a component outside a box body rather than box body itself, which saves an occupied area of the box body and avoids the size of the box body being too large due to assembly with the hanging members, and thus it is beneficial to meeting the miniaturization requirements of electrical device in the conventional technology. An electrical device hanging system and a photovoltaic power station having the electrical device are further provided in the present application, to meet the miniaturization requirements of the electrical device in the conventional technology.

To achieve the above objects, the following technical solutions are provided according to the present application.

An electrical device includes a box body and multiple hanging members, where a component is mounted outside the box body, the multiple hanging members are fixed to the component separately, and a first hanging member and a second hanging member of the multiple hanging members are distributed on two sides of the box body.

Preferably, in the electrical device, the first hanging member and the second hanging member are fixed to different components of multiple components, respectively.

Preferably, in the electrical device, a first component of the multiple components is configured to enclose a second component of the multiple components, and the first hanging member is fixed to the first component, or the first hanging member is extended through the first component to be fixed to the second component.

Preferably, in the electrical device, a third component and a fourth component of the multiple components are immediately adjacently arranged side by side, and the fourth component is proximate to a side edge of the box body; the second hanging member is fixed to the fourth component, or the second hanging member is extended through the fourth component to be fixed to the third component.

Preferably, in the electrical device, the first component, the second component and the box body are arranged in a stacked manner, and the first component is fixed to the box body through the second component, and the first hanging member is fixed to the first component, or fixed to the second component, or fixed between the first component and the second component.

Preferably, in the electrical device, the first hanging member and the second hanging member are fixed to the first component and the second component, respectively, and the first hanging member is located at a side of the first component away from the second component, and the second hanging member is located at a side of the second component away from the first component.

Preferably, in the electrical device, the first hanging member and the second hanging member are fixed to the same component, and the first hanging member and the second hanging member are arranged on two opposite sides of the same component.

Preferably, in the electrical device, the first component is mounted on the box body, the second component and the first component are arranged in a stacked manner, the second component is fixed to the box body through the first component, and the first hanging member and the second hanging member are fixed at two ends of the first component, respectively; or
the first component and the second component are arranged in a stacked manner, the first component is fixed to the box body through the second component, and the first hanging member and the second hanging member are fixed at two ends of the first component, respectively.

Preferably, in the electrical device, the multiple hanging members and the component fixedly connected to the multiple hanging members are integrally formed; or, the multiple hanging members and the component fixedly connected to the multiple hanging members are separate from each other and are fixedly connected by threaded connection, welding, bonding, or riveting.

An electrical device hanging system is provided, including the electrical device according to any one of the above solutions, and a hanging plate, where each of the multiple hanging members is fitted with a hanging notch of the hanging plate.

Preferably, the hanging notch is located at an upper edge of the hanging member.

Preferably the hanging plate is fixedly connected to the electrical device through a first fastener, and the hanging plate is provided with a through hole fitted with the first fastener, and the electrical device is provided with a threaded hole fitted with the first fastener.

A photovoltaic power station is provided, including the electrical device hanging system according to any one of the above solutions.

An electrical device is provided in the present application, including a box body and multiple hanging members, a component is mounted outside the box body, the multiple hanging members are fixed to the component separately, and a first hanging member and a second hanging member of the multiple hanging members are distributed on two sides of the box body.

In the electrical device according to the present application, the hanging member is mounted to the component outside the box body rather than being directly mounted on the box body, which saves an occupied area of the box body and avoids the size of the box body from being too large due to assembly with the hanging members, and thus it is beneficial to meeting the miniaturization requirements of the electrical device in the conventional technology. In addition, the box body does not need to have a large size, which can also save costs.

An electrical device hanging system and a photovoltaic power station having the electrical device are further provided in the present application, which meet the miniaturization requirements of the electrical device in the conventional technology.

### BRIEF DESCRIPTION OF THE DRAWINGS

For more clearly illustrating embodiments of the present application or the technical solutions in the conventional technology, drawings referred to describe the embodiments or the conventional technology will be briefly described hereinafter. Apparently, the drawings in the following description are only some examples of the present application, and for those skilled in the art, other drawings may be obtained based on these drawings without any creative efforts.
FIG. 1 is a schematic structural view of an electrical device according to a first embodiment of the present application;
FIG. 2 is a schematic structural view of an electrical device according to a second embodiment of the present application;
FIG. 3 is a schematic structural view of an electrical device according to a third embodiment of the present application;
FIG. 4 is a schematic structural view of an electrical device according to a fourth embodiment of the present application;
FIG. 5 is a schematic structural view of the electrical device according to the fourth embodiment of the present application from another perspective;
FIG. 6 is a schematic structural view of a first type of electrical device according to a fifth embodiment of the present application;
FIG. 7 is a schematic structural view of a second type of electrical device according to the fifth embodiment of the present application;
FIG. 8 is a schematic structural view of a third type of electrical device according to the fifth embodiment of the present application;
FIG. 9 is a schematic view showing a hanging member and a component being integrally formed with each other according to an embodiment of the present application;
FIG. 10 is a schematic view showing a hanging member and a component being separate from each other according to an embodiment of the present application;
FIG. 11 is a schematic view showing the component being assembled with the box body of the electrical device according to an embodiment of the present application;
FIG. 12 is an exploded view of an electrical device hanging system according to an embodiment of the present application; and
FIG. 13 is a schematic structural view of the electrical device hanging system according to the embodiment of the present application.

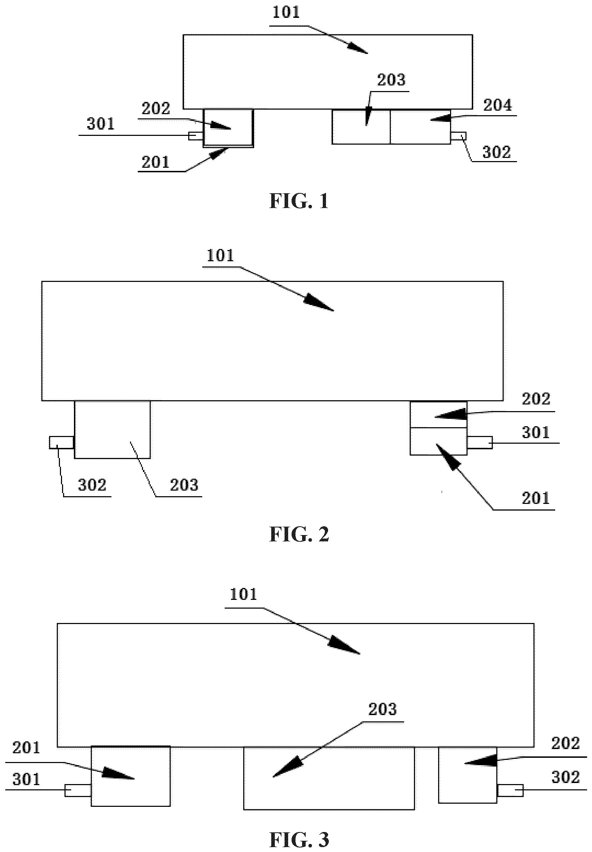

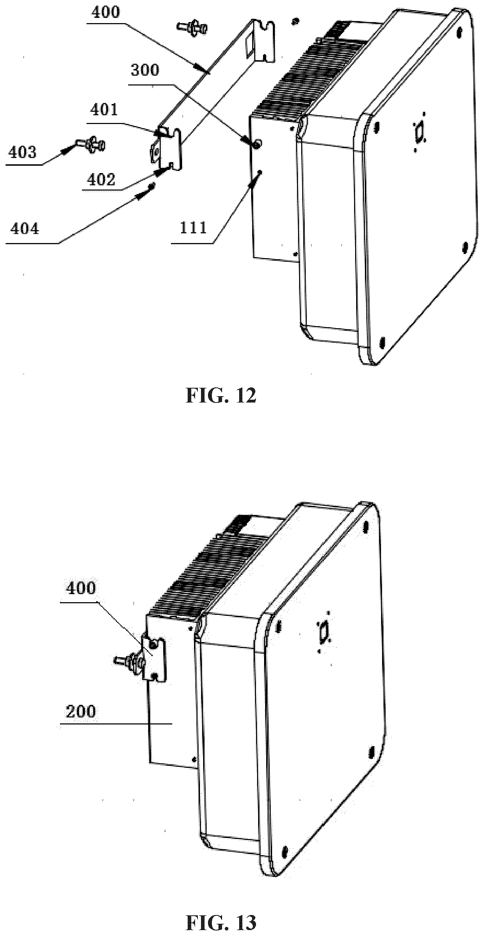

**Reference numerals in FIG. 1 to FIG. 13:**

| | | | |
|---|---|---|---|
| 101 | box body, | 111 | threaded hole, |
| 200 | component, | 201 | first component, |
| 211 | radiator, | 212 | air duct, |
| 202 | second component, | 203 | third component, |
| 204 | fourth component, | 300 | hanging member, |
| 301 | first hanging member, | 302 | second hanging member, |
| 400 | hanging plate, | 401 | hanging notch, |
| 402 | through hole, | 403 | second fastener, |
| 404 | first fastener. | | |

### DETAILED DESCRIPTION OF THE EMBODIMENTS

An electrical device is provided according to embodiments of the present application, a hanging member of the electrical device is mounted to a component outside a box body rather than the box body itself, which saves an occupied area of the box body and avoids the size of the box body from being too large due to assembly with the hanging member, and thus it is beneficial to meeting the miniaturization requirements of the electrical device in the conventional technology. An electrical device hanging system and a photovoltaic power station that employ the electrical device are further provided in the embodiments of the present application, to meet the miniaturization requirements of the electrical device in the conventional technology.

Technical solutions according to the embodiments of the present application will be described clearly and completely as follows in conjunction with the accompany drawings in the embodiments of the present application. It is obvious that the described embodiments are only a part of the embodiments according to the present application, rather than all of the embodiments. All the other embodiments obtained by those skilled in the art based on the embodiments in the present application without any creative work belong to the scope of protection of the present application.

Referring to FIG. 1 to FIG. 13, an electrical device is provided in the present application, which includes a box body 101 and multiple hanging members 300. A component 200 is mounted outside the box body 101. Each of the hanging members 300 is fixed to the component 200 separately, and a first hanging member 301 and a second hanging member 302 of the hanging member 300 are distributed on two opposite sides of the box body 101.

In the electrical device according to the embodiment of the present application, the hanging member 300 is mounted to the component 200 outside the box body 101 rather than being directly mounted on the box body 101, saving an occupied area of the box body 101 and avoiding the size of the box body 101 from being too large due to assembly with the hanging member 300, which is beneficial to meeting the miniaturization requirements of the electrical device in the conventional technology. In addition, the box body 101 does not need to have a large size, which also saves costs.

For ease of mounting, the hanging member 300 is configured to be rod-shaped. A base end of the hanging member 300 is fixed to the component 200, and a free end of the hanging member 300 extends in a direction away from the box body 101. A free end of the first hanging member 301 and a free end of the second hanging member 302 extend in opposite directions.

Further, the first hanging member 301 and the second hanging member 302 are mounted to positions of the component 200 close to opposite side edges of the box body 101, respectively, to ensure that the first hanging member 301 and the second hanging member 302 are distributed on two opposite sides of the box body 101, which facilitates hanging.

In the electrical device, the first hanging member 301 and the second hanging member 302 may be fixed to different components 200, respectively, which is described in detail hereinafter in conjunction with the drawings.

### First Embodiment

Referring to FIG. 1, in an electrical device according to this embodiment, a first component 201 encloses a second component 202. The first hanging member 301 is fixed to the first component 201 or the second component 202, or, the first hanging member 301 is extended through the first component 201 to be fixed to the second component 202.

In addition, in the electrical device according to this embodiment, a third component 203 and a fourth component 204 are immediately adjacently arranged side by side, with the fourth component 204 being closer to a side edge of the box body 101. The second hanging member 302 is fixed to the fourth component 204, or, the second hanging member 302 is extended through the fourth component 204 to be fixed to the third component 203.

### Second Embodiment

Referring to FIG. 2, in an electrical device according to this embodiment, the first component 201, the second component 202 and the box body 101 are arranged in a stacked manner. The first component 201 is fixed to the box body 101 through the second component 202. The first hanging member 301 is fixed to the first component 201, or fixed to the second component 202, or fixed between the first component 201 and the second component 202.

The first component 201 and the second component 202 are located close to one side edge of the box body 101, the third component 203 is located close to the other side edge of the box body 101, and the second hanging member 302 is fixed to the third component 203.

### Third Embodiment

Referring to FIG. 3, in an electrical device according to this embodiment, the first hanging member 301 and the second hanging member 302 are fixed to the first component 201 and the second component 202, respectively. The first hanging member 301 is located at a side of the first component 201 away from the second component 202, and the second hanging member 302 is located at a side of the second component 202 away from the first component 201.

In this embodiment, the first hanging member 301 and the second hanging member 302 are located close to two side edges of the box body 101, respectively, and other components 200, for example a third component 203, may be arranged between the first hanging member 301 and the second hanging member 302. The other components are spaced apart from the first component 201 and the second component 202.

### Fourth Embodiment

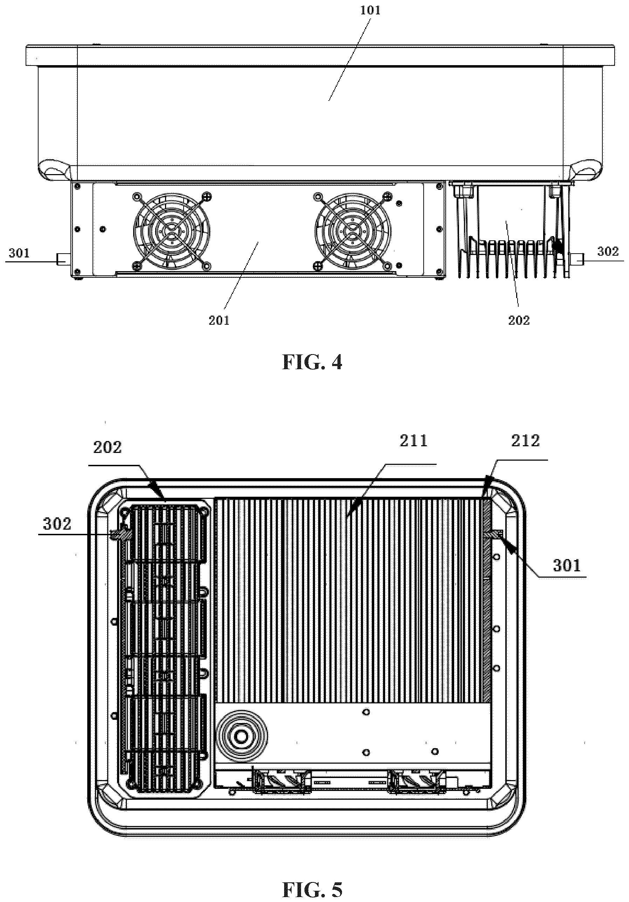

Referring to FIG. 4 and FIG. 5, in an electrical device according to this embodiment, the first hanging member 301 and the second hanging member 302 are fixed to the first component 201 and the second component 202, respectively. The first hanging member 301 is located at a side of the first component 201 away from the second component 202, and the second hanging member 302 is located at a side of the second component 202 away from the first component 201. The first component 201 may be an integrated component consisting of a radiator 211 and an air duct 212, and the second component 202 may be a reactor. The type of the component 200 used to fix the hanging member 300 is not limited in the embodiment.

In the above first to fourth embodiments, the first hanging member 301 and the second hanging member 302 are assembled at different positions of different components 200 respectively. The first hanging member 301 and the second hanging member 302 may also be mounted in other ways according to the structure and arrangement of the components 200 mounted outside the box body 101 of the electrical device. For example, the first hanging member 301 and the second hanging member 302 may be respectively fixed to the same component 200, and the first hanging member 301 and the second hanging member 302 are arranged at two opposite sides of this component 200. The arrangement is not limited in this embodiment, as long as it is ensured that the first hanging member 301 and the second hanging member 302 are arranged at two opposite sides of the box body 101. The solutions are described in detail hereinafter in conjunction with the drawings.

### Fifth Embodiment

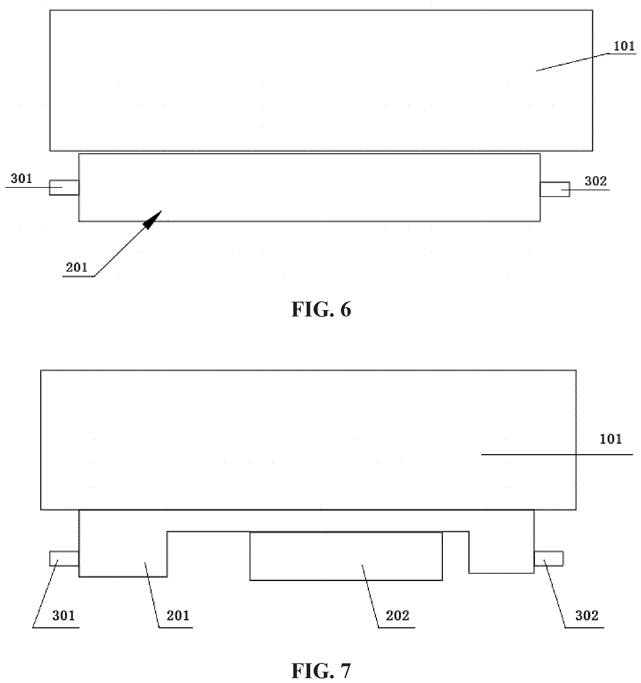

Referring to FIG. 6, in an electrical device according to an embodiment of the present application, the first hanging member 301 and the second hanging member 302 are fixed at two opposite ends of the first component 201, respectively. The first component 201 is relatively long, to ensure that the first hanging member 301 and the second hanging member 302 are arranged at two opposite sides of the box body 101, which facilitates hanging.

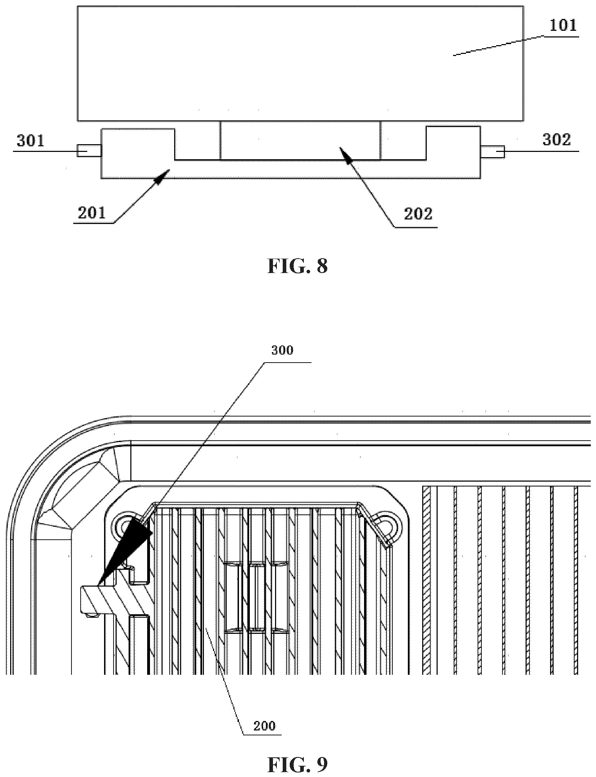

The first component 201 is directly fixed to the box body 101 without being connected with other components 200. According to layout requirements of the components 200 in the electrical device, the second component 202, the first component 201, and the box body 101 may be sequentially arranged in a stacked manner. The first component 201 is mounted on the box body 101, the second component 202 is fixed to the box body 101 through the first component 201, and the first hanging member 301 and the second hanging member 302 are fixed at two opposite ends of the first component respectively, as shown in FIG. 7. Alternatively, the first component 201, the second component 202, and the box body 101 are sequentially arranged in a stacked manner, the first component 201 is mounted to the box body 101 through the second component 202, and the first hanging member 301 and the second hanging member 302 are fixed at two opposite ends of the first component 201 respectively, as shown in FIG. 8.

The arrangement and method for mounting the first component 201, configured for mounting the first hanging member 301 and the second hanging member 302, outside the box body 101 is not limited in this embodiment, as long as it is ensured that the first hanging member 301 and the second hanging member 302 are arranged on two sides of the box body 101.

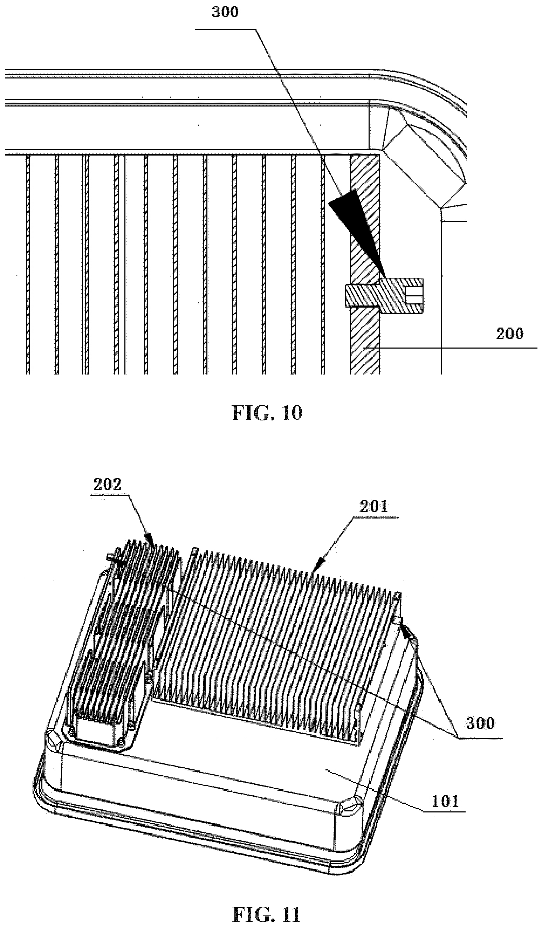

The hanging member 300 and the component 200 fixedly connected therewith may be integrally formed, as shown in FIG. 9. Alternatively, the hanging member 300 and the component 200 fixedly connected therewith may be separate from each other, and are fixedly connected with each other by threaded connection (as shown in FIG. 10), welding, bonding, or riveting, which is not limited in this embodiment. Each component 200 is externally mounted on the box body 101. The expression "externally mounted" refers to that the component 200 and box body 101 are separate from each other rather than being integrally formed. Specifically, each component 200 may be fixed to box body 101 by fasteners (such as screws), bonding, riveting, welding, and so on, which is not limited in this embodiment.

In the electrical device according to the above embodiments, each of the components 200 may be configured as one or a combination of the following components 200: a reactor, a radiator 211, and an air duct 212. Of course, the components 200 may also be of other types according to the type of the electrical device, which is not limited in this embodiment.

According to the electrical device in this embodiment, the hanging members 300 are employed to replace the mounting brackets, leading to a smaller volume and a lower cost. Additionally, the electrical device in this embodiment has a simple structure, which is easy to manufacture.

An electrical device hanging system is further provided in the present application, including an electrical device and a hanging plate 400. The electrical device is the electrical device according to the above embodiments, and the hanging member 300 is fitted with a hanging notch 401 of the hanging plate 400.

Preferably, the hanging notch 401 is provided at an upper edge of the hanging member 300, which not only facilitates the installation of the electrical device but also ensures that the hanging member 300 can be reliably clamped into the hanging notch 401 under a gravity of the electrical device itself after installation.

Furthermore, in the electrical device hanging system above, the hanging plate 400 is fixedly connected to the electrical device through a detachable first fastener 404. The hanging plate 400 is provided with a through hole 402 fitted with the first fastener 404, and the electrical device is provided with a threaded hole 111 fitted with the first fastener 404.

In the electrical device hanging system according to this embodiment, the first fastener 404 is provided to connect the electrical device and the hanging plate 400, which can prevent the electrical device from rotating, thereby improving the reliability of hanging of the electrical device. Meanwhile, the electrical device and the hanging plate 400 are fixed with each other through the first fastener 404, which further improves an anti-theft performance of the electrical device.

Specifically, the threaded hole 111 of the electrical device is formed in the box body 101 or the component 200, which is not limited in this embodiment. The first fastener 404 is a fastening screw for the whole electrical device. The hanging plate 400 may be mounted on the installation foundation in site, such as a wall, a bracket, a pillar, and so on through a second fastener 403, such as a hanging-plate fastening screw, which is not limited in this embodiment.

A photovoltaic power station is further provided according to the embodiment of the present application, including the electrical device hanging system according to the above embodiments.

The electrical device above is employed in the electrical device hanging system and the photovoltaic power station according to the embodiments of the present application, respectively, which can meet the miniaturization requirements of the electrical device in the conventional technology. Of course, the electrical device hanging system and the photovoltaic power station provided in the embodiments of the present application further have other effects related to electrical device in the above embodiments, which will not be repeated here.

The above embodiments in this specification are described in a progressive manner. Each of the embodiments is mainly focused on describing its differences from other embodiments, and references may be made among these embodiments with respect to the same or similar portions among these embodiments.

Based on the above description of the disclosed embodiments, those skilled in the art are capable of carrying out or using the present application. It is obvious for those skilled in the art to make many modifications to these embodiments. The general principle defined herein may be applied to other embodiments without departing from the spirit or scope of the present application. Therefore, the present application is not limited to the embodiments illustrated herein, but should be defined by the broadest scope consistent with the principle and novel features disclosed herein.

## Claims

1. An electrical device, comprising a box body and a plurality of hanging members, wherein
a component is mounted outside the box body, the plurality of hanging members are fixed to the component separately, and a first hanging member and a second hanging member of the plurality of hanging members are distributed on two sides of the box body.

2. The electrical device according to claim 1, wherein the number of the component is plural, and the first hanging member and the second hanging member are fixed to different components of the plurality of components, respectively.

3. The electrical device according to claim 2, wherein a first component of the plurality of components is configured to enclose a second component of the plurality of components,
the first hanging member is fixed to the first component, or the first hanging member is extended through the first component to be fixed to the second component.

4. The electrical device according to claim 2 or 3, wherein a third component and a fourth component of the plurality of components are immediately adjacently arranged side by side, and the fourth component is proximate to a side edge of the box body; and
the second hanging member is fixed to the fourth component, or the second hanging member is extended through the fourth component to be fixed to the third component.

5. The electrical device according to claim 2, wherein the first component, the second component and the box body are arranged in a stacked manner, and the first component is fixed to the box body through the second component,
the first hanging member is fixed to the first component, or fixed to the second component, or fixed between the first component and the second component.

6. The electrical device according to claim 2, wherein the first hanging member and the second hanging member are fixed to a first component and a second component of the plurality of components, respectively; and
the first hanging member is located at a side of the first component away from the second component, and the second hanging member is located at a side of the second component away from the first component.

7. The electrical device according to claim 1, wherein the first hanging member and the second hanging member are fixed to the same component, and the first hanging member and the second hanging member are arranged on two opposite sides of the same component.

8. The electrical device according to claim 7, wherein
a first component is mounted on the box body, a second component and the first component are arranged in a stacked manner, and the second component is fixed to the box body through the first component, wherein the first hanging member and the second hanging member are fixed at two ends of the first component, respectively; or
a first component and a second component are arranged in a stacked manner, and the first component is fixed to the box body through the second component, wherein the first hanging member and the second hanging member are fixed at two ends of the first component, respectively.

9. The electrical device according to claim 1, wherein
the plurality of hanging members and the component fixedly connected to the plurality of hanging members are integrally formed; or
the plurality of hanging members and the component fixedly connected to the plurality of hanging members are separate from each other and are fixedly connected by threaded connection, welding, bonding, or riveting.

10. An electrical device hanging system, comprising the electrical device according to any one of claims 1 to 9, and a hanging plate, wherein each of the plurality of hanging members is fitted with a hanging notch of the hanging plate.

11. The electrical device hanging system according to claim 10, wherein the hanging notch is located at an upper edge of the hanging member.

12. The electrical device hanging system according to claim 10, wherein the hanging plate is fixedly connected to the electrical device through a first fastener, the hanging plate is provided with a through hole fitted with the first fastener, and the electrical device is provided with a threaded hole fitted with the first fastener.

13. A photovoltaic power station, comprising the electrical device hanging system according to any one of claims 10 to 12.
